# EUROPEAN PATENT SPECIFICATION

(11) **EP 2 544 248 B1**
(45) Date of publication and mention of the grant of the patent: **31.08.2016**
(21) Application number: 12156087.4
(22) Date of filing: 17.02.2012
(51) Int. Cl.: H01L 33/02, H01L 33/22

(54) **Light emitting device**
Lichtemittierende Vorrichtung
Dispositif électroluminescent

(30) Priority: 08.07.2011 KR 20110067691; 22.09.2011 KR 20110095967
(43) Date of publication of application: 09.01.2013
(73) Proprietor: LG Innotek Co., Ltd., Seoul 100-714 (KR)
(72) Inventor: Moon, Yong Tae, 100-714 Seoul (KR); Song, Yong Seon, 100-714 Seoul (KR); Jung, Sung Hoon, 100-714 Seoul (KR); Park, Joong Seo, 100-714 Seoul (KR); Lee, Sang Jun, 100-714 Seoul (KR); Oh, Jeong Tak, 100-714 Seoul (KR); Choi, Rak Jun, 100-714 Seoul (KR)
(74) Representative: Cabinet Plasseraud

(56) References cited:
- US-A1- 2004 056 242
- US-A1- 2006 260 671
- US-A1- 2007 145 406

## Description

### BACKGROUND

The present disclosure relates to a light emitting device, a method of manufacturing a light emitting device, a light emitting device package, and a lighting system.

Light emitting devices are used to convert electric energy into light energy. For example, light emitting diodes (LEDs) can emit light of various colors if the compositions of compound semiconductors of LEDs are varied.

In the related art, light emitting devices are manufactured using nitride semiconductors. For example, a light emitting device of the related art includes a p-GaN layer, an active layer, and an n-GaN layer, see for example US2004/05 6242.

In a method of the related art, the surface of an n-GaN layer is made rough by chemical etching to improve light extraction efficiency.

However, such a chemical etching method results in etching depth non-uniformity in n-GaN epi layers.

For example, a portion of an n-GaN epi layer may be excessively etched away, which causes current leakage and decreases electrical and optical reliability. Particularly, if a crystal defect region of an n-GaN epi layer is excessively etched, the reliability of a light emitting device is seriously decreased.

Particularly, in the case of light emitting devices for large and high-power lighting systems, due to a large amount of current and a large light emitting area, the reliability of light emitting devices is more important as compared with light emitting devices for small and low-power systems.

In addition, nitride semiconductor light emitting devices inevitably have many crystal defects such as threading dislocations. Particularly in vertical type light emitting devices, such crystal defects form a current leakage path between positive and negative electrodes, and when an n-GaN layer is etched, regions around crystal defects are greatly etched than other regions to seriously decrease the electric reliability of light emitting devices.

### SUMMARY

Embodiments provide a light emitting device having improved electrical and optical characteristics, a method of manufacturing a light emitting device, a light emitting device package, and a lighting system.

In one embodiment, a light emitting device comprises: a first conductive type first semiconductor layer; an active layer on the first conductive type first semiconductor layer; a second conductive type second semiconductor layer on the active layer; a reliability enhancement layer on the second conductive type second semiconductor layer; and a second conductive type third semiconductor layer disposed on the reliability enhancement layer and comprising a light extraction pattern, wherein the reliability enhancement layer and the active layer are spaced apart from each other by a distance of 0.3 µm to 5 µm.

In another embodiment, a light emitting device comprises: a first conductive type first semiconductor layer; an active layer on the first conductive type first semiconductor layer; a second conductive type second semiconductor layer on the active layer; a reliability enhancement layer comprising a protrusion and disposed on the second conductive type second semiconductor layer; and a second conductive type third semiconductor layer on the reliability enhancement layer.

In further another embodiment, a light emitting device package comprises: a package body; at least one electrode layer on the package body; the light emitting device electrically connected to the electrode layer; and a molding member on the light emitting device.

In still further another embodiment, a lighting system comprises a light emitting module part, the light emitting module part including a board and the light emitting device package disposed on the board.

The details of one or more embodiments are set forth in the accompanying drawings and the description below. Other features will be apparent from the description and drawings, and from the claims.

### BRIEF DESCRIPTION OF THE DRAWINGS

Fig. 1 is a cross-sectional view illustrating a light emitting device according to a first embodiment.
Fig. 2A is a graph illustrating a relationship between modal index and electron injection layer thickness (t).
Fig. 2B is a graph illustrating a relationship between a reverse breakdown voltage Vr and a distance between a reliability enhancement layer and an active layer in a light emitting device.
Figs. 3 to 9 are cross-sectional views for explaining a method of manufacturing a light emitting device according to the first embodiment.
Fig. 10 is a cross-sectional view illustrating a light emitting device according to a second embodiment.
Fig. 11 is a partially enlarged view illustrating the light emitting device of the second embodiment.
Figs. 12 to 18 are sectional views for explaining a method of manufacturing a light emitting device according to an embodiment.
Fig. 19 is a cross-sectional view illustrating a light emitting device package according to an embodiment.
Fig. 20 is a perspective view illustrating a lighting unit according to an embodiment.
Fig. 21 is a perspective view illustrating a backlight unit according to an embodiment.

### DETAILED DESCRIPTION OF THE EMBODIMENTS

Hereinafter, a light emitting device, a light emitting device package, and a lighting system will be described according to exemplary embodiments with reference to the accompanying drawings.

In the description of embodiments, it will be understood that when a layer (or film) is referred to as being 'on' another layer or substrate, it can be directly on another layer or substrate, or intervening layers may also be present. Further, it will be understood that when a layer is referred to as being 'under' another layer, it can be directly under another layer, and one or more intervening layers may also be present. In addition, it will also be understood that when a layer is referred to as being 'between' two layers, it can be the only layer between the two layers, or one or more intervening layers may also be present.

### (First Embodiment)

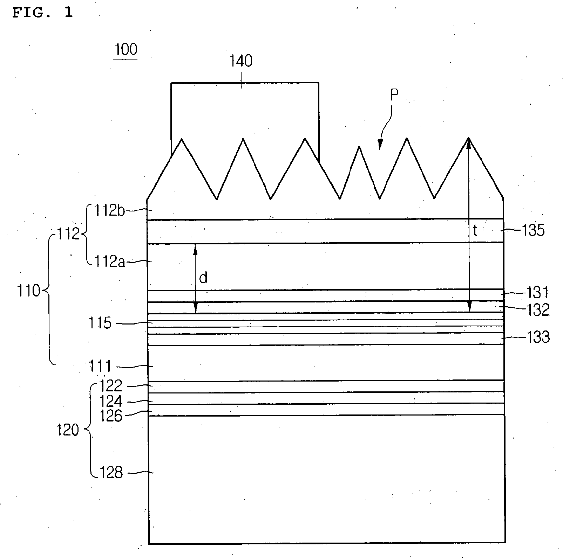

FIG. 1 is a cross-sectional view illustrating a light emitting device 100 according to a first embodiment.

The light emitting device 100 of the first embodiment may include: a first conductive type first semiconductor layer 111; an active layer 115 on the first conductive type first semiconductor layer 111, a second conductive type second semiconductor layer 112a on the active layer 115; a reliability enhancement layer 135 on the second conductive type second semiconductor layer 112a; and a second conductive type third semiconductor layer 112b on the reliability enhancement layer 135.

In the first embodiment, the reliability enhancement layer 135 may function as an etching reliability enhancement layer and a current leakage prevention layer. However, the function of the reliability enhancement layer 135 is not limited thereto.

The second conductive type second semiconductor layer 112a and the second conductive type third semiconductor layer 112b may constitute a second conductive type semiconductor layer 112 that functions as an electron injection layer.

The first conductive type first semiconductor layer 111, the active layer 115, and the second conductive type semiconductor layer 112 may constitute a light emitting structure 110. A pad electrode 140 may be disposed on the second conductive type semiconductor layer 112.

In the first embodiment, the second conductive type third semiconductor layer 112b may include a light extraction pattern (P) to improve light extraction efficiency and thus to increase the output power of the light emitting device 100.

In the first embodiment, excessive etching can be prevented owing to the reliability enhancement layer 135 when a chemical etching process is performed to form the light extraction pattern (P). For example, when an etching process is performed to form the light extraction pattern (P) on the second conductive type third semiconductor layer 112b, the reliability enhancement layer 135 may function as an etch stop layer to prevent the second conductive type second semiconductor layer 112a from being etched. In this way, the reliability enhancement layer 135 can improve the reliability of the etching process.

In detail, the second conductive type semiconductor layer 112 may be exposed after a light emitting diode (LED) epi thin layer is separated from a thin layer growing substrate such as a sapphire substrate. At this time the second conductive type semiconductor layer 112 has a flat surface, and thus the second conductive type semiconductor layer 112 is wet-etched or dry-etched so that the second conductive type semiconductor layer 112 can have an irregular or regular rough surface so as to improve light extraction efficiency.

Since the chemical or physical etching rate of the reliability enhancement layer 135 is lower than that of the second conductive type semiconductor layer 112, chemical etching is substantially stopped at the reliability enhancement layer 135. Therefore, a portion of a thin film is not unevenly or excessively etched owing to the reliability enhancement layer 135. That is, the second conductive type semiconductor layer 112 can have a uniform etching depth across the entirety thereof.

In an embodiment, the reliability enhancement layer 135 may reduce dry etching damage when a dry etching is performed to form a light extraction pattern. If the reliability enhancement layer 135 has a high concentration of aluminum (Al), the reliability enhancement layer 135 may function as an etch stop layer when a dry etching process is performed.

As described above, in the current embodiment, the etching depth of the second conductive type semiconductor layer 112 can be uniform across the entirety thereof owing to the reliability enhancement layer 135, the optical and electrical characteristics of the light emitting device 100 can be improved, and the yield of a manufacturing process of the light emitting device 100 can be increased.

The reliability enhancement layer 135 may be formed of the same kind of material as that used to form the second conductive type semiconductor layer 112 and may be doped with the same conductive type dopant as that used to dope the second conductive type semiconductor layer 112. However, materials that can be used to form the reliability enhancement layer 135 are not limited thereto.

For example, the reliability enhancement layer 135 may include a nitride-containing semiconductor such as InₓAl_{y}Ga(_{1-x-y})N(0≤x≤1, 0≤y≤<1) and may be doped with a second conductive type dopant. For example, if the second conductive type semiconductor layer 112 include an n-type nitride semiconductor, the reliability enhancement layer 135 may include n-type InₓAl_{y}Ga_{(1-x-y)}N(0≤x≤1, 0≤y≤1).

In the first embodiment, the distance (d) between the reliability enhancement layer 135 and the active layer 115 may be in the range from about 0.3 µm to about 5 µm.

If the active layer 115 is excessively distant from the reliability enhancement layer 135 disposed in the second conductive type semiconductor layer 112 which is an electron injection layer, the thickness of the rough light extraction pattern (P) formed by etching may be too small, and the interval of ridges of the light extraction pattern (P) may be too large to form flat portions between the ridges of the light extraction pattern (P). This reduces light extraction efficiency.

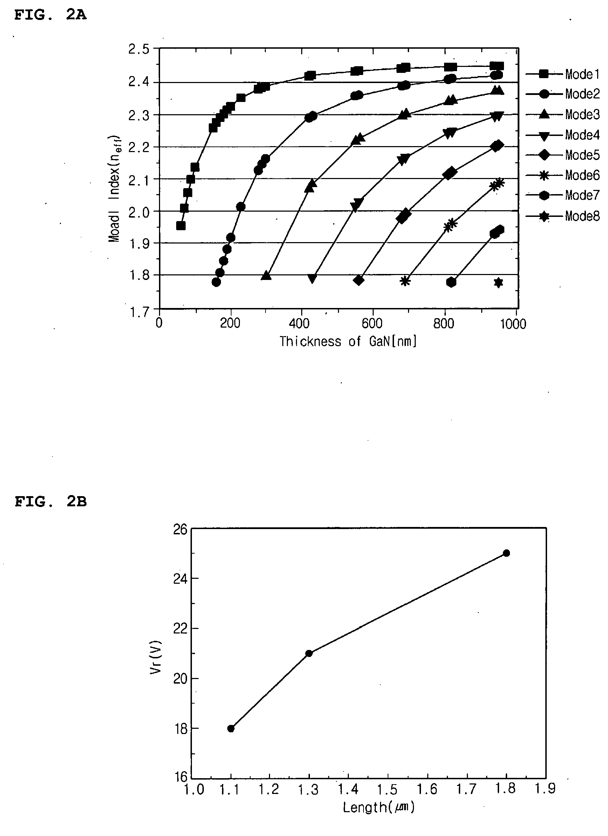

Fig. 2A is a graph illustrating a relationship between modal index and electron injection layer thickness (t).

For example, most of photons emitted from the active layer 115 have a fundamental mode. However, photons having a fundamental mode are difficult to extract because the modal index of the fundamental mode is high. As the thickness of the second conductive type semiconductor layer 112 which is an electron injection layer is small, the modal index decreases to increase light extraction efficiency, and the thickness of the second conductive type semiconductor layer 112 is great, the modal index increases to decrease light extraction efficiency.

Thus, in the first embodiment, if the distance (d) between the reliability enhancement layer 135 and the active layer 115 is greater than 5 µm, since the thickness of the second conductive type semiconductor layer 112 is great, the modal index is great and the light extraction pattern (P) is relatively flat. Thus, light extraction efficiency is reduced. That is, when the distance (d) between the reliability enhancement layer 135 and the active layer 115 is smaller than 5 µm, satisfactory etch stop function and light extraction efficiency may be obtained.

However, if the distance (d) between the reliability enhancement layer 135 is small, the second conductive type third semiconductor layer 112b may be excessively etched when an etching rough light extraction pattern (P) is performed to form surface roughness such as the light extraction pattern (P) on the second conductive type third semiconductor layer 112b. In this case, the reliability enhancement layer 135 may not suppress current leakage of the light emitting device 100 due to current concentration on an excessively etched local area of the second conductive type third semiconductor layer 112b.

Fig. 2B is a graph illustrating a relationship between a reverse breakdown voltage Vr and a distance between the reliability enhancement layer 135 and the active layer 115 in the light emitting device 100.

If the distance (d) between the reliability enhancement layer 135 and the active layer 115 is smaller than 0.3 µm, the reverse breakdown voltage Vr of the light emitting device 100 is low as shown in Fig. 2B.

In addition, if the distance (d) the reliability enhancement layer 135 and the active layer 115 is too small, electrons injected into the second conductive type second semiconductor layer 112a through the reliability enhancement layer 135 are not effectively distributed in a horizontal direction.

If electrons are injected into the active layer 115 in a state where the electrons are not effectively distributed horizontally in the second conductive type second semiconductor layer 112a, light emitting efficiency at the active layer 115 is lowered, and distribution of emitted light is not uniform. Electrons injected into a nitride semiconductor material have an effective diffusion distance of about 0.2 µm.

Therefore, in the first embodiment, the distance (d) between the reliability enhancement layer 135 and the active layer 115 may be about 0.3 µm or greater so as to effectively suppress current leakage by the reliability enhancement layer 135 and inject electrons into the active layer 115 in a state where the electrons are uniformly distributed in a horizontal direction.

Furthermore, in the first embodiment, the reliability enhancement layer 135 may have a thickness in the range from about5 nm to about 200 nm.

If the thickness of the reliability enhancement layer 135 is smaller than 5 nm, the reliability enhancement layer 135 may not properly function as an etch stop layer. That is, etching may hot be stopped at the reliability enhancement layer 135. For example, in a dry etching process, the physicochemical crystalline characteristics of a surface of an etch stop layer are deteriorated due to etching damage. Therefore, in the current embodiment, the thickness of the reliability enhancement layer 135 may be about 5 nm or greater.

If the thickness of the reliability enhancement layer 135 is greater than about 200 nm, the efficiency of current injection from the pad electrode 140 to the active layer 115 is decreased, and the resistance of the light emitting device 100 is increased. As compared with the second conductive type semiconductor layer 112 which is an electron injection layer, the reliability enhancement layer 135 has more aluminum (Al) and a greater energy band gap. Therefore, the electron conductivity of the reliability enhancement layer 135 is lower than that of the second conductive type semiconductor layer 112. Therefore, the reliability enhancement layer 135 may have a thickness in the range from about 5 nm to about 200 nm.

In the first embodiment, the reliability enhancement layer 135 may include InₓAl_{y}Ga_{(1-x-y)}N (0≤x≤1, 0<y≤1). Specifically, the aluminum composition (y) may be 0.05≤y≤0.5.

For example, if the second conductive type semiconductor layer 112 which is an n-type electron injection layer has a matrix formed of gallium nitride (GaN) or a nitride semiconductor having an energy band gap similar to that of GaN, the reliability enhancement layer 135 formed of a nitride semiconductor and disposed in the matrix of the second conductive type semiconductor layer 112 may have an aluminum composition (y) in the range from about 0.05 to about 0.5 (0.05≤y≤0.5).

As the aluminum composition (y) of the reliability enhancement layer 135 increases, the energy band gap of the reliability enhancement layer 135 increases, and n-type electric conductivity characteristics of the second conductive type semiconductor layer 112 decrease. In the first embodiment, if the aluminum composition (y) of the reliability enhancement layer 135 is about 5% or less, the difference between the energy band gap of the reliability enhancement layer 135 and the energy band gap of GaN (n-type electron injection layer) is small, and the etch selectivity of the second conductive type semiconductor layer 112 on the reliability enhancement layer 135 is low. That is, the reliability enhancement layer 135 may not function as an etch stop layer.

Furthermore, in the first embodiment, the reliability enhancement layer 135 may have an energy band gap wider than that of the second conductive type third semiconductor layer 112b. Accordingly, the energy band level of the reliability enhancement layer 135 may be higher than that of the second conductive type third semiconductor layer 112b, and thus the reliability enhancement layer 135 may function as an etch stop layer.

For example, if the second conductive type semiconductor layer 112 which is an n-type electron injection layer has a matrix formed of gallium aluminum nitride such as InₚAl_{q}Ga_{1-p-q}N (0≤p≤1, 0≤q≤1, 0≤p+q≤1), the reliability enhancement layer 135 formed of a nitride semiconductor and disposed in the matrix of the second conductive type semiconductor layer 112 may effectively function as an etch stop layer when the aluminum composition of the reliability enhancement layer 135 is greater than the aluminum composition of the matrix.

For example, if the second conductive type third semiconductor layer 112b includes a semiconductor material having a composition formula of InₚAl_{q}Ga_{1-p-q}N (0≤p≤1, 0≤q≤1, 0≤p+q≤1) and the reliability enhancement layer 135 includes InₓAl_{y}Ga(_{1-x-y})N (0≤x≤1, 0 < y≤1), the energy band gap of the reliability enhancement layer 135 may be set to be greater than that of the second conductive type third semiconductor layer 112b by adjusting the aluminum (Al) composition of the reliability enhancement layer 135 to be greater than that of the second conductive type third semiconductor layer 112b or the indium (In) composition of the reliability enhancement layer 135 to be smaller than that of the second conductive type third semiconductor layer 112b. However, the current embodiment is not limited thereto.

For example, the aluminum composition (y) of the reliability enhancement layer 135 may be set to q+0.05≤y≤q+0.5 (0≤q≤0.5) so that the reliability enhancement layer 135 can effectively function as an etch stop layer.

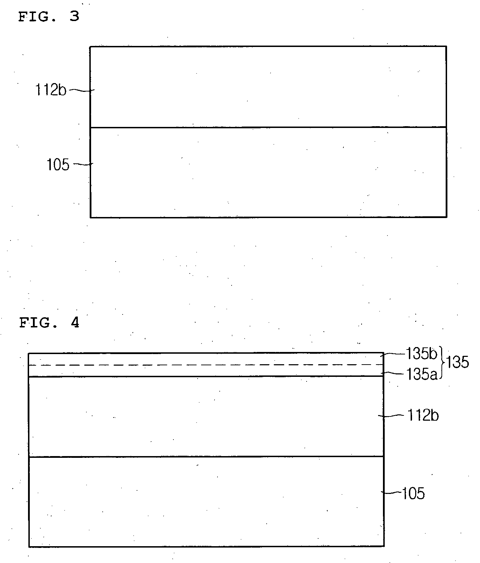

Furthermore, in the first embodiment, the reliability enhancement layer 135 may include first and second reliability enhancement layers 135a and 135b (refer to Fig. 4) that have different energy band gaps. In this case, the aluminum composition or energy band gap of the reliability enhancement layer 135 may be gradually reduced in a growing direction or a direction toward the active layer 115. In addition, the indium composition (x) of the reliability enhancement layer 135 may be gradually reduced in the direction toward the active layer 115.

Furthermore, in the first embodiment, the reliability enhancement layer 135 may have a superlattice structure formed by alternately stacking first and second reliability enhancement layer 135a and 135b having different energy band gaps. Also, the reliability enhancement layer 135 may have a multi-layed structure formed by first and second reliability enhancement layer.

In the first embodiment, if the reliability enhancement layer 135 has a multi-layer structure as described above, current injection efficiency of the light emitting device 100 may be increased as compared with the case where the reliability enhancement layer 135 has a single-layer structure.

In the first embodiment, a second electrode layer 120 may be disposed under the second conductive type second semiconductor layer 112a to effectively supply carriers and thus to increase the output power of the light emitting device 100. The second electrode layer 120 may include an ohmic layer 122, a reflection layer 124, a coupling layer 126, and a second substrate 128. However, the second electrode layer 120 is not limited thereto.

Furthermore, in the first embodiment, a current diffusion layer 131 and a strain control layer 132 may be disposed between the second conductive type second semiconductor layer 112a and the active layer 115, and an electron block layer 133 may be disposed between the active layer 115 and the first conductive type first semiconductor layer 111.

As described above, embodiments can provide a light emitting device having improved electrical and optical characteristics, a method of manufacturing a light emitting device, a light emitting device package, and a lighting system.

In addition, embodiments can provide a light emitting device in which excessive etching of a thin film does not occur owing to a reliability enhancement layer during a chemical etching process, a method of manufacturing a light emitting device, a light emitting device package, and a lighting system. For example, when an etching process is performed to form a light extraction pattern on a layer, the etching depth of the light extraction pattern can be uniform across the entire region of the layer owing to a reliability enhancement layer. Thus, a light emitting device having improved optical and electrical characteristics can be produced with a high yield.

In addition, embodiments can provide a highly reliable and high-power light emitting device in which a reliability enhancement layer is disposed in a second conductive type semiconductor layer to prevent current leakage caused by crystal dislocation defects, a method of manufacturing a light emitting device, a light emitting device package, and a lighting system.

In addition, embodiments can provide a high-power light emitting device in which a current is blocked by a reliability enhancement layer to increase light emitting efficiency by a current spreading effect, a method of manufacturing a light emitting device, a light emitting device package, and a lighting system.

Hereinafter, a method of manufacturing a light emitting device and technical characteristics thereof will be described according to the first embodiment with reference to Figs. 3 to 9.

First, a first substrate 105 is prepared as illustrated in Fig. 3. The first substrate 105 may include a conductive substrate or an insulating substrate. For example, the first substrate 105 may include at least one of sapphire (Al₂O₃), SiC, Si, GaAs, GaN, ZnO, GaP, InP, Ge, and Ga₂O₃. A concave-convex structure may be disposed on the upper portion of the first substrate 105. However, the first substrate 105 is not limited thereto. A wet cleaning process may be performed on the first substrate 105 to remove impurities from the surface of the first substrate 105.

In a later process, a light emitting structure 110 including a second conductive type semiconductor layer 112, an active layer 115, and a first conductive type first semiconductor layer 111 may be formed on the first substrate 105.

A buffer layer (not shown) may be disposed on the first substrate 105. The buffer layer may reduce a lattice mismatch between materials of the light emitting structure 110 and the first substrate 105. The buffer layer may be formed of a group III-V compound semiconductor. For example, the buffer layer may be formed of at least one GaN, InN, AlN, InGaN, AlGaN, InAlGaN, and AlInN.

Next, a second conductive type third semiconductor layer 112b may be disposed on the first substrate 105.

The second conductive type third semiconductor layer 112b may be formed of a group III-V compound semiconductor doped with a second conductive type dopant. If the second conductive type third semiconductor layer 112b is an n-type semiconductor layer, the second conductive type dopant may include Si, Ge, Sn, Se, or Te as an n-type dopant. However, the second conductive type dopant is not limited thereto.

The second conductive type third semiconductor layer 112b may include a semiconductor material having a composition equation of InₚAl_{q}Ga_{1-p-q}N (0≤p≤1, 0≤q≤1, 0≤p+q≤1). For example, the second conductive type third semiconductor layer 112b may include at least one of GaN, InN, AlN, InGaN, AIGaN, InAlGaN, AlInN, AlGaAs, InGaAs, AlInGaAs, GaP, AlGaP, InGaP, AlInGaP, and InP.

The second conductive type third semiconductor layer 112b may be formed as an n-type GaN layer by using a method such as chemical vapor deposition (CVD), molecular beam epitaxy (MBE), sputtering, or hydride vapor phase epitaxy (HVPE). The second conductive type third semiconductor layer 112b may be formed by injecting silane (SiH₄) gas including n-type impurities such as trimethyl gallium (TMGa) gas, ammonia (NH₃) gas, nitrogen (N₂) gas, and silicon (Si) into a chamber.

Next, as shown in Fig. 4, a reliability enhancement layer 135 may be disposed on the second conductive type third semiconductor layer 112b according to the first embodiment.

For example, the reliability enhancement layer 135 may include a second conductive type InₓAl_{y}Gal_{(1-x-y)}N (0≤x≤1, 0≤y≤1) and may have a single-layer or multi-layer structure. For example, the reliability enhancement layer 135 may include first and second reliability enhancement layers 135a and 135b having different energy band gaps. In this case, the aluminum composition or energy band gap of the reliability enhancement layer 135 may be gradually reduced in a growing direction or a direction toward an active layer. In addition, the indium composition of the reliability enhancement layer 135 may be gradually reduced in the direction toward the active layer.

Furthermore, in the first embodiment, the reliability enhancement layer 135 may have a superlattice structure formed by alternately stacking first and second reliability enhancement layer 135a and 135b having different energy band gaps.

In the first embodiment, if the reliability enhancement layer 135 has a multi-layer structure, current injection efficiency can be increased as compared with the case where the reliability enhancement layer 135 has a single-layer structure.

In the first embodiment, the etching rate of the reliability enhancement layer 135 may be lower than that of the second conductive type third semiconductor layer 112b. In the first embodiment, for example, the aluminum composition of the reliability enhancement layer 135 may be adjusted be greater than the aluminum composition of the second conductive type third semiconductor layer 112b or the indium composition of the reliability enhancement layer 135 may be adjusted to be less than the indium composition of the second conductive type third semiconductor layer 112b, so as to make the etching rate of the reliability enhancement layer 135 lower than that of the second conductive type third semiconductor layer 112b.

In the first embodiment, as the aluminum composition of a layer increases, the chemical etching rate of the layer may decrease, and as the indium composition of the layer increases, the chemical etching rate of the layer may increase. The reason for this is that the chemical bonding between Al atoms and N atoms is stronger than the chemical bonding between Ga atoms and N atoms and the chemical bonding between Ga atoms and N atoms is stronger than the chemical bonding between In atoms and N atoms.

In the first embodiment, since the chemical etching rate of the reliability enhancement layer 135 is lower than that of the second conductive type third semiconductor layer 112b, chemical etching can be substantially stopped at the reliability enhancement layer 135. Therefore, local non-uniform excessive chemical etching of the light emitting structure 110 can be effectively stopped by the reliability enhancement layer 135.

That is, the first embodiment can provide a light emitting device in which excessive etching of a thin film can be prevented by a reliability enhancement layer, and a method of manufacturing the light emitting device.

In the first embodiment, the electrical resistance of the reliability enhancement layer 135 may be greater than that of the second conductive type third semiconductor layer 112b. For example, the reliability enhancement layer 135 may include InₓAl_{y}Ga(_{1-x-y)}N (0≤x≤1, 0≤y≤1) that has an energy band gap greater than that of the second conductive type third semiconductor layer 112b so that the reliability enhancement layer 135 can be chemically stable and have electrical resistance greater than that of the second conductive type third semiconductor layer 112b.

According to the first embodiment, since the reliability enhancement layer 135 is disposed in the second conductive type semiconductor layer 112, current leakage caused by crystal dislocation defects can be effectively prevented, and thus a highly reliable high-power light emitting device can be provided for a large light system.

In addition, since a current is blocked by the reliability enhancement layer 135, light extraction efficiency can be improved by a current spreading effect, and thus a high-power light emitting device can be provided.

In the first embodiment, the reliability enhancement layer 135 may have a thickness in the range from about 5 nm to about 200 nm.

If the thickness of the reliability enhancement layer 135 is smaller than about 5 nm, the reliability enhancement layer 135 may not properly function as an etch stop layer. That is, etching may not be stopped at the reliability enhancement layer 135. For example, in a dry etching process, the physicochemical crystalline characteristics of a surface of the reliability enhancement layer 135 may be deteriorate due to etching damage. Therefore, in the current embodiment, the thickness of the reliability enhancement layer 135 may be set to about 5 nm or greater.

If the thickness of the reliability enhancement layer 135 is greater than about 200 nm, the efficiency of current injection from a pad electrode to an active layer may be decreased, and the resistance of a light emitting device may be increased. As compared with the second conductive type semiconductor layer 112 which is an electron injection layer, the reliability enhancement layer 135 has more aluminum (Al) and a greater energy band gap. Therefore, the electron conductivity of the reliability enhancement layer 135 is lower than that of the second conductive type semiconductor layer 112. Therefore, the reliability enhancement layer 135 may have a thickness in the range from about 5 nm to about 200 nm.

The reliability enhancement layer 135 may be formed of the same kind of material as that used to form the second conductive type semiconductor layer 112 and may be doped with the same conductive type dopant as that used to dope the second conductive type semiconductor layer 112. However, the reliability enhancement layer 135 is not limited thereto.

For example, the reliability enhancement layer 135 may include a nitride-containing semiconductor such as InₓAl_{y}Ga(_{1-x-y})N (0≤x≤1, 0≤y≤1) and may be doped with a second conductive type dopant. For example, if the second conductive type semiconductor layer 112 includes an n-type nitride semiconductor, the reliability enhancement layer 135 may include n-type InₓAl_{y}Ga_{(1-x-y)}N(0≤x≤1, 0<y≤1).

Furthermore, in the first embodiment, the reliability enhancement layer 135 may include InₓAlyGa(_{1-x-y})N(0≤x≤1, 0 < y≤1), and the aluminum composition (y) may be 0.05≤y≤0.5.

For example, if the second conductive type semiconductor layer 112 which is an n-type electron injection layer has a matrix formed of gallium nitride (GaN) or a nitride semiconductor having a band gap similar to that of GaN, the reliability enhancement layer 135 formed of a nitride semiconductor and disposed in the matrix of the second conductive type semiconductor layer 112 may have an aluminum composition (y) in the range from about 0.05 to about 0.5 (0.05≤y≤0.5).

As the aluminum composition (y) increases, the energy band gap of the reliability enhancement layer 135 increases, and n-type electric conductivity characteristics of the second conductive type semiconductor layer 112 decrease. In the first embodiment, if the aluminum composition (y) of the reliability enhancement layer 135 is about 5% or less, the difference between the energy band gap of the reliability enhancement layer 135 and the energy band gap of GaN (n-type electron injection layer) is small, and the etch selectivity of the second conductive type semiconductor layer 112 on the reliability enhancement layer 135 is low. That is, the reliability enhancement layer 135 does not function as an etch stop layer.

Furthermore, in the first embodiment, the reliability enhancement layer 135 may have an energy band gap greater than that of the second conductive type third semiconductor layer 112b. Accordingly, since the energy band level of the reliability enhancement layer 135 is higher than that of the second conductive type third semiconductor layer 112b, the reliability enhancement layer 135 can function as an etch stop layer.

For example, if the second conductive type semiconductor layer 112 which is an n-type electron injection layer has a matrix formed of gallium aluminum nitride such as InₚAl_{q}Ga_{1-p-q}N (0≤p≤1, 0≤q≤1, 0≤p+q≤1), the reliability enhancement layer 135 formed of a nitride semiconductor and disposed in the matrix of the second conductive type semiconductor layer 112 effectively functions as an etch stop layer when the aluminum composition of the reliability enhancement layer 135 is greater than the aluminum composition of the matrix.

For example, if the second conductive type third semiconductor layer 112b includes a semiconductor material having a composition formula of InₚAl_{q}Ga_{1-p-q}N (0≤p≤1, 0≤q≤1, 0≤p+q≤1) and the reliability enhancement layer 135 includes InₓAl_{y}Ga_{(1-x-y)}N (0≤x≤1, 0 < y≤1), the energy band gap of the reliability enhancement layer 135 can be set to be greater than that of the second conductive type third semiconductor layer 112b by adjusting the aluminum (Al) composition of the reliability enhancement layer 135 to be greater than that of the second conductive type third semiconductor layer 112b or the indium (In) composition of the reliability enhancement layer 135 to be smaller than that of the second conductive type third semiconductor layer 112b. However, the current embodiment is not limited thereto.

For example, the aluminum composition (y) of the reliability enhancement layer 135 may be set to q+0.05≤y≤q+0.5 (0≤q≤0.5) so that the reliability enhancement layer 135 can effectively function as an etch stop layer.

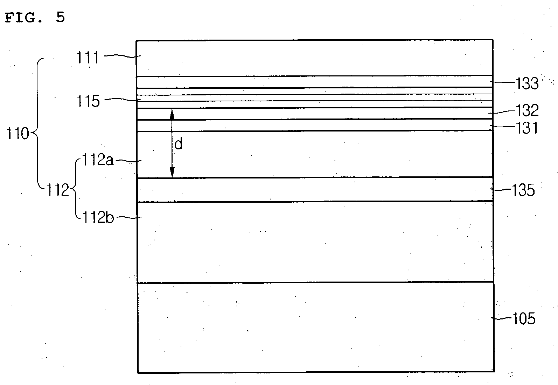

Next, as shown in Fig. 5, a second conductive type second semiconductor layer 112a is disposed on the reliability enhancement layer 135. The second conductive type second semiconductor layer 112a may be formed of the same kind of material as that used to form the second conductive type third semiconductor layer 112b.

For example, the second conductive type second semiconductor layer 112a may include a semiconductor material having a composition formula of InₚAl_{q}Ga_{1-p-q}N (0≤p≤1, 0≤q≤1, 0≤p≤1). However, the second conductive type second semiconductor layer 112a is not limited thereto.

Thereafter, a current diffusion layer 131 is disposed on the second conductive type second semiconductor layer 112a. The current diffusion layer 131 may be an undoped GaN layer. However, the current diffusion layer 131 is not limited thereto.

Next, according to the first embodiment, an electron injection layer (not shown) may be disposed on the current diffusion layer 131. The electron injection layer may be a second conductive type gallium nitride layer. For example, the electron injection layer may be doped with an n-type dopant for effective electron injection. The concentration of the n-type dopant in the electron injection layer may be about 6.0x10¹⁸ atoms/cm³ to about 8.0x10¹⁸ atoms/cm³.

Next, according to the first embodiment, a strain control layer 132 may be disposed on the electron injection layer. For example, the strain control layer 132 may be formed on the electron by using a material such as In_{y}AlₓGa(_{1-x-y})N (0≤x≤1, 0≤y≤1)/GaN.

The strain control layer 132 may reduce a stress caused by a lattice mismatch between the second conductive type semiconductor layer 112 and an active layer 115.

The strain control layer 132 may be formed by stacking a first Inₓ₁GaN and a second Inₓ₂GaN at least six times so that more electrons can be collected in the active layer 115 having a low energy level. In this case, the possibility of electron and hole recombination can be increased to increase light extraction efficiency.

After that, the active layer 115 is disposed on the strain control layer 132.

The active layer 115 may have at least one of a single quantum well structure, a multi quantum well (MQW) structure, a quantum-wire structure, and a quantum dot structure. For example, the active layer 115 may be formed into a multi quantum well (MQW) structure by injecting trimethyl gallium (TMGa) gas, ammonia (NH₃) gas, nitrogen (N₂) gas, and trimethyl indium (TMIn) gas. However, the active layer 115 is not limited thereto.

The active layer 115 may have a well layer/barrier layer pair structure constituted by at least one of InGaN/GaN, InGaN/InGaN, GaN/AlGaN, InAlGaN/GaN, GaAs(InGaAs)/AlGaAs, and GaP(InGaP)/AlGaP. However, the active layer 115 is not limited thereto. The well layer may be formed of a material having a lower band gap than that of the barrier layer.

In the first embodiment, the active layer 115 may be spaced apart from the reliability enhancement layer 135 by a distance (d) of about 0.3 µm to about 5 µm.

Thus, in the first embodiment, if the distance (d) between the reliability enhancement layer 135 and the active layer 115 is greater than 5 µm, since the thickness of the second conductive type semiconductor layer 112 is great, modal index is high and a light extraction pattern (P) is relatively flat. Thus, light extraction efficiency is reduced. That is, when the distance (d) between the reliability enhancement layer 135 and the active layer 115 is smaller than 5 µm, satisfactory etch stop function and light extraction efficiency can be obtained.

Furthermore, in the first embodiment, the distance (d) between the reliability enhancement layer 135 and the active layer 115 may be set to about 0.3 µm or greater so as to effectively suppress current leakage by the reliability enhancement layer 135 and inject electrons into the active layer 115 in a state where the electrons are uniformly distributed in a horizontal direction.

Next, according to the first embodiment, an electron block layer 133 is disposed on the active layer 115 for blocking electrons and functioning as a MQW cladding layer for the active layer 115. That is, light extraction efficiency can be improved by forming the electron block layer 133. For example, the electron block layer 133 may be formed of a semiconductor including AlₓIn_{y}Ga(_{1-x-y})N (0≤x≤1,0≤y≤1). The electron block layer 133 may have an energy band gap wider than that of the active layer 115. The electron block layer 133 may have a thickness of about 100 Å to about 600 Å.

In addition, the electron block layer 133 may have a superlattice structure formed of Al_{z}G₃(_{1-z})N/GaN (0≤z≤1). However, the electron block layer 133 is not limited thereto.

P-type ions may be injected into the electron block layer 133 so that the electron block layer 133 can effectively block overflowing electrons and improve hole injection efficiency. For example, magnesium (Mg) ions may be injected into the electron block layer 133 at a concentration of about 10¹⁸ to about 10²⁰/cm³ so that the electron block layer 133 can effectively block overflowing electrons and improve hole injection efficiency.

Next, a first conductive type first semiconductor layer 111 is disposed on the electron block layer 133. The first conductive type first semiconductor layer 111 may include a group III-V compound semiconductor doped with a first conductive type dopant. For example, the first conductive type first semiconductor layer 111 may include a semiconductor material having a composition formula of InₓAl_{y}Ga_{1-x-y}N (0≤x≤1, 0≤y≤1, 0≤x+y≤1). If the first conductive type first semiconductor layer 111 is a p-type semiconductor layer, the first conductive type dopant may include Mg, Zn, Ca, Sr, and Ba.

The first conductive type first semiconductor layer 111 may be formed as a p-type GaN layer by injecting trimethyl gallium (TMGa) gas, ammonia (NH₃) gas, nitrogen (N₂) gas, and bis-ethyl-cyclopentadienyl-magnesium (EtCp₂Mg){Mg(C₂H₅C₅H₄)₂} including a p-type dopant such as Mg into a chamber. However, the first conductive type first semiconductor layer 111 is not limited thereto.

In the first embodiment, the second conductive type semiconductor layer 112 may be an n-type semiconductor layer, and the first conductive type first semiconductor layer 111 may be a p-type semiconductor layer. However, the first embodiment is not limited thereto. A semiconductor having a conductive type opposite to the first conductive type may be disposed on the first conductive type first semiconductor layer 111. For example, an n-type semiconductor layer (not shown) may be disposed on the first conductive type first semiconductor layer 111. Accordingly, the light emitting structure 110 may have one of an n-p junction structure, a p-n junction structure, an n-p-n junction structure, and a p-n-p junction structure.

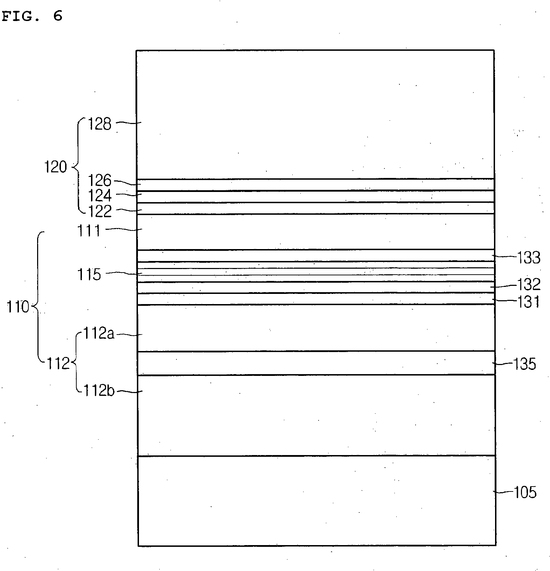

Next, as shown in Fig. 6, a second electrode layer 120 is disposed on the first conductive type first semiconductor layer 111.

The second electrode layer 120 may include an ohmic layer 122, a reflection layer 124, a coupling layer 126, and a second substrate 128. The second electrode layer 120 may be formed of at least one of titanium (Ti), chrome (Cr), nickel (Ni), aluminum (Al), platinum (Pt), gold (Au), tungsten (W), and a semiconductor substrate doped with a dopant.

For example, the second electrode layer 120 may include an ohmic layer 122 and may have a multi-layer structure formed of a metal, a metal alloy, or a metal oxide to improve hole injection efficiency. For example, the ohmic layer 122 may include at least one of indium tin oxide (ITO), indium zinc oxide (IZO), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IZON (IZO Nitride), AGZO (Al-Ga ZnO), IGZO (In-Ga ZnO), ZnO, IrOx, RuOx, NiO, RuOx/ITO, Ni/IrOx/Au, Ni/IrOx/Au/ITO, Ag, Ni, Cr, Ti, Al, Rh, Pd, Ir, Ru, Mg, Zn, Pt, Au, and Hf. However, the ohmic layer 122 is not limited thereto.

If the second electrode layer 120 includes the reflection layer 124, the second electrode layer 120 may be formed of a material including Al, Ag, or an alloy containing Al or Ag. Aluminum (Al) or silver (Ag) effectively reflects light emitted from the active layer 115 so that the light extraction efficiency of a light emitting device can be significantly improved.

If the second electrode layer 120 includes the coupling layer 126, the reflection layer 124 may function as the coupling layer 126, or the coupling layer 126 may be formed of a material such as nickel (Ni) or gold (Au).

In addition, the second electrode layer 120 may include the second substrate 128. The second substrate 128 may be formed of a metal, a metal alloy, or a conductive semiconductor material having high electric conductivity for improving hole injection efficiency. For example, the second substrate 128 may selectively include copper (Cu), gold (Au), copper alloy, nickel (Ni), copper-tungsten (Cu-W), and a carrier wafer (e.g., GaN, Si, Ge, GaAs, ZnO, SiGe, or SiC wafer).

The second substrate 128 may be disposed by a method such as an electrochemical metal deposition method and a bonding method using a eutectic metal.

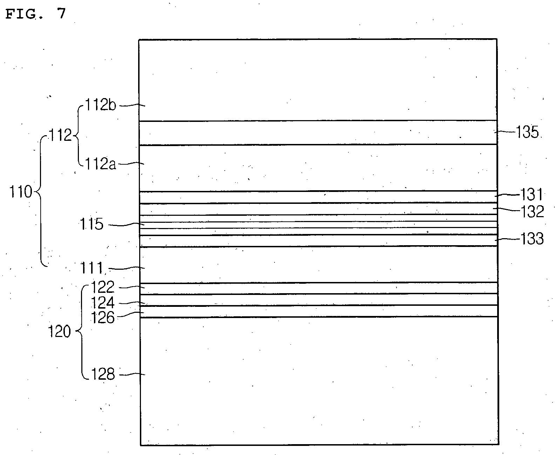

Thereafter, as illustrated in Fig. 7, the first substrate 105 is removed to expose the first conductive type semiconductor layer 112. The first substrate 105 may be removed using a high power laser or a chemical etch method. Alternatively, the first substrate 105 may be removed using a physical grinding method.

For example, in a laser lift-off method, energy is applied to the first substrate 105 and the light emitting structure 110. Then, as the interfacial region between the first substrate 105 and the light emitting structure 110 absorbs the energy, the contact surface of the light emitting structure 110 thermally decomposes, and thus the first substrate 105 can be separated from the light emitting structure 110.

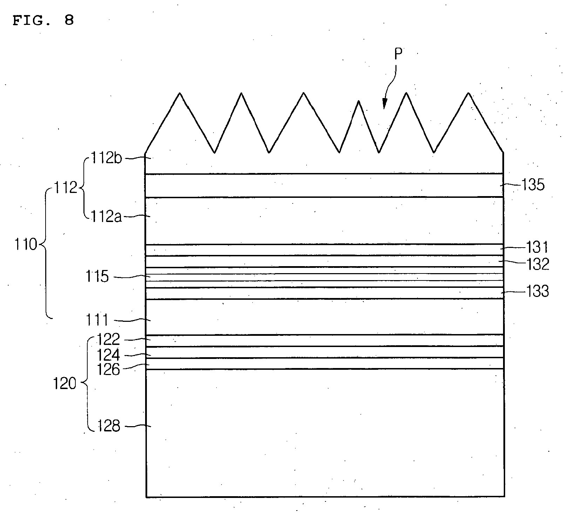

Next, according to the first embodiment, a light extraction pattern (P) may be formed on the exposed surface of the second conductive type third semiconductor layer 112b as shown in Fig. 8.

When an etching process is performed to form the light extraction pattern (P) on the second conductive type third semiconductor layer 112b, the reliability enhancement layer 135 functions as an etch stop layer to prevent the second conductive type second semiconductor layer 112a from being etched. In this way, the reliability enhancement layer 135 can improve the reliability of the etching process.

For example, in the first embodiment, when the light emitting structure 110 (epi thin layers) is separated from the first substrate 105 which may be a sapphire substrate for growing a thin film, the exposed second conductive type third semiconductor layer 112b may have a flat surface. Then, the surface of the second conductive type third semiconductor layer 112b may be made rough by a chemical etching method to improve light extraction efficiency. For example, the light extraction pattern (P) may be formed on the second conductive type third semiconductor layer 112b to make rough the surface of the second conductive type third semiconductor layer 112b.

In the first embodiment, the etching rate of the reliability enhancement layer 135 may be lower than that of the second conductive type third semiconductor layer 112b.

In the first embodiment, as the aluminum composition of a layer increases, the chemical etching rate of the layer may decrease, and as the indium composition of the layer increases, the chemical etching rate of the layer may increase. The reason for this is that the chemical bonding between Al atoms and N atoms is stronger than the chemical bonding between Ga atoms and N atoms and the chemical bonding between Ga atoms and N atoms is stronger than the chemical bonding between In atoms and N atoms.

In the first embodiment, since the chemical etching rate of the reliability enhancement layer 135 is lower than that of the second conductive type third semiconductor layer 112b, chemical etching can be substantially stopped at the reliability enhancement layer 135. Therefore, local non-uniform excessive chemical etching of the light emitting structure 110 can be effectively stopped by the reliability enhancement layer 135.

For example, if the reliability enhancement layer 135 includes InₓAl_{y}Ga_{(1-x-y)}N (0≤x≤1, 0≤y≤1), the energy band gap of the reliability enhancement layer 135 can be increased by adjusting the aluminum composition (y) of the reliability enhancement layer 135 to be greater than that of the second conductive type third semiconductor layer 112b or the indium composition (x) to be smaller than that of the second conductive type third semiconductor layer 112b. However, the reliability enhancement layer 135 is not limited thereto.

In the first embodiment, since the chemical or physical etching rate of the reliability enhancement layer 135 is lower than that of the second conductive type semiconductor layer 112, chemical etching is substantially stopped at the reliability enhancement layer 135. Therefore, a portion of a thin film is not unevenly or excessively etched owing to the reliability enhancement layer 135. That is, the second conductive type semiconductor layer 112 can have a uniform etching depth across the entirety thereof.

Furthermore, in the first embodiment, the reliability enhancement layer 135 can reduce dry etching damage when a dry etching is performed to form the light extraction pattern (P) on the second conductive type third semiconductor layer 112b. If the aluminum composition of the reliability enhancement layer 135 is high, the reliability enhancement layer 135 can function as an etch stop layer when a dry etching process is performed.

As described above, in the current embodiment, the etching depth of the second conductive type third semiconductor layer 112b can be uniform across the entirety thereof owing to the reliability enhancement layer 135. Therefore, the optical and electrical characteristics of a light emitting device can be improved, and the yield of a manufacturing process of a light emitting device can be increased.

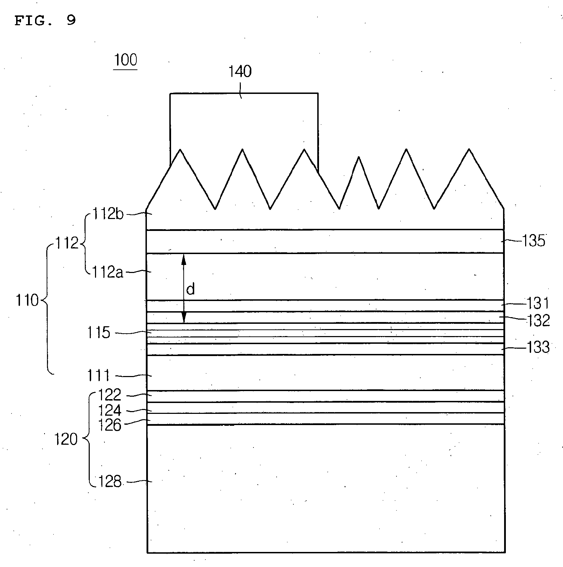

Next, as shown in Fig. 9, a pad electrode 140 may be disposed on the second conductive type third semiconductor layer 112b on which the light extraction pattern (P) is formed. In this way, a light emitting device 100 can be manufactured according to the first embodiment.

As described above, embodiments can provide a light emitting device having improved electric and optical characteristics, a method of manufacturing a light emitting device, a light emitting device package, and a lighting system.

In addition, embodiments can provide a light emitting device in which excessive etching of a thin film does not occur owing to a reliability enhancement layer during a chemical etching process, a method of manufacturing a light emitting device, a light emitting device package, and a lighting system. For example, when an etching process is performed to form a light extraction pattern on a layer, the etching depth of the light extraction pattern can be uniform across the entire region of the layer owing to a reliability enhancement layer. Thus, a light emitting device having improved optical and electrical characteristics can be produced with a high yield.

In addition, embodiments can provide a highly reliable and high-power light emitting device in which a reliability enhancement layer is disposed in a second conductive type semiconductor layer to prevent current leakage caused by crystal dislocation defects, a method of manufacturing a light emitting device, a light emitting device package, and a lighting system.

In addition, embodiments can provide a high-power light emitting device in which a current is blocked by a reliability enhancement layer to increase light emitting efficiency by a current spreading effect, a method of manufacturing a light emitting device, a light emitting device package, and a lighting system.

### (Second Embodiment)

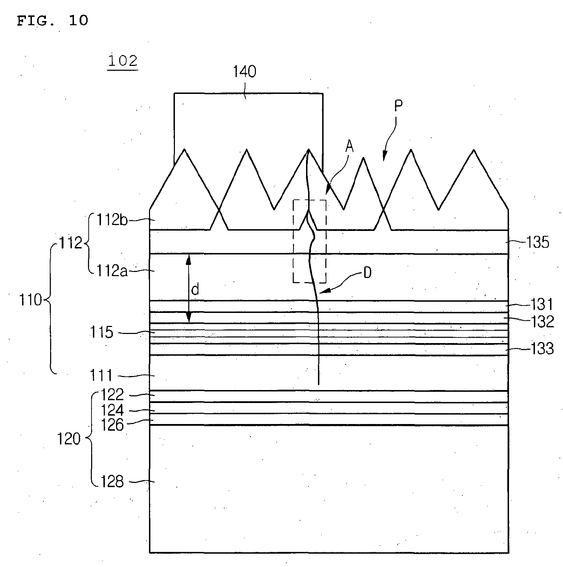

Fig. 10 is a cross-sectional view illustrating a light emitting device 102 according to a second embodiment.

The light emitting device 102 of the second embodiment may include the technical characteristics of the light emitting device 100 of the first embodiment.

The light emitting device 102 of the second embodiment may include: a first conductive type first semiconductor layer 111; an active layer 115 on the first conductive type first semiconductor layer 111; a second conductive type second semiconductor layer 112a on the active layer 115; a reliability enhancement layer 135 including protrusions and disposed on the second conductive type second semiconductor layer 112a; and a second conductive type third semiconductor layer 112b on the reliability enhancement layer 135.

In the second embodiment, the reliability enhancement layer 135 may function as an etching reliability enhancement layer and a current leakage prevention layer. However, the function of the reliability enhancement layer 135 is not limited thereto.

The second conductive type second semiconductor layer 112a and the second conductive type third semiconductor layer 112b may constitute a second conductive type semiconductor layer 112 that functions as an electron injection layer.

The first conductive type first semiconductor layer 111, the active layer 115, and the second conductive type semiconductor layer 112 may constitute a light emitting structure 110. A pad electrode 140 may be disposed on the second conductive type semiconductor layer 112.

The reliability enhancement layer 135 may be formed of the same kind of material as that used to form the second conductive type semiconductor layer 112 and may be doped with the same conductive type dopant as that used to dope the second conductive type semiconductor layer 112.

The reliability enhancement layer 135 may have an energy band gap greater than that of the second conductive type third semiconductor layer 112b. Accordingly, since the energy band level of the reliability enhancement layer 135 is higher than that of the second conductive type third semiconductor layer 112b, the reliability enhancement layer 135 can function as an etch stop layer.

In the current embodiment, the second conductive type third semiconductor layer 112b may include a light extraction pattern (P) to improve light extraction efficiency and thus to increase the output power of the light emitting device 102.

When an etching process is performed to form the light extraction pattern (P) on the second conductive type third semiconductor layer 112b, the reliability enhancement layer 135 functions as an etch stop layer to prevent the second conductive type second semiconductor layer 112a from being etched. In this way, the reliability enhancement layer 135 can improve the reliability of the etching process.

In the light emitting device 102 of the second embodiment, the energy band gap of the reliability enhancement layer 135 is greater than that of the second conductive type third semiconductor layer 112b, and the reliability enhancement layer 135 is relatively thicker than the second conductive type third semiconductor layer 112b at a region around a crystal defect (D). Therefore, leakage of a reverse or forward low current can be prevented at the region around the crystal defect (D) such as a crystal dislocation, and thus the reliability of the light emitting device 102 can be remarkably improved.

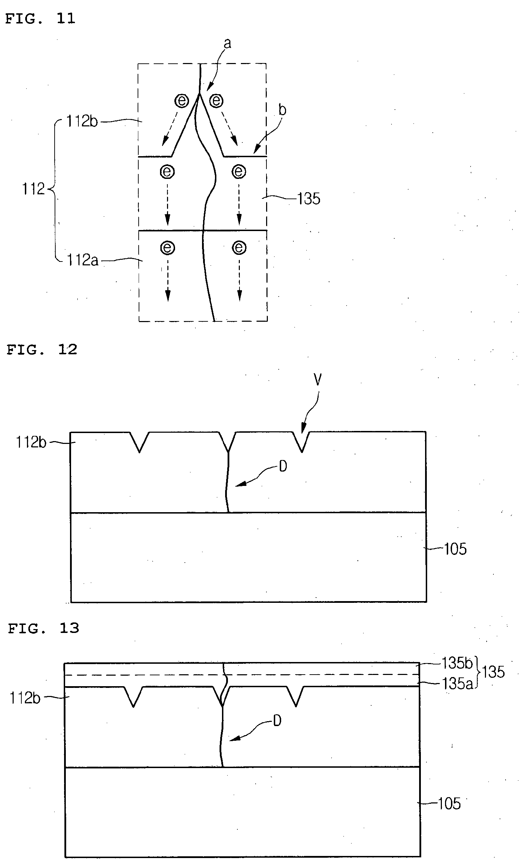

Fig. 11 is a partially enlarged view illustrating a portion (A) of the light emitting device 102 of the second embodiment. For example, Fig. 11 illustrates a partial enlarged view of the reliability enhancement layer 135 of the light emitting device 102 of the second embodiment.

A nitride semiconductor light emitting device inevitably has many crystal dislocation defects in a film thereof, and such crystal dislocation defects form main current leakage paths. Therefore, electric reliability of the light emitting device is significantly decreased.

In the second embodiment, the reliability enhancement layer 135 may be thicker at the region around the crystal defect (D) than other regions. For example, a protrusion (a) of the reliability enhancement layer 135 may be located in a region of the crystal defect (D). In this case, the resistance of the reliability enhancement layer 135 is higher at the protrusion (a) located at the crystal defect (D) than at a flat region (b), and thus carrier electrons ⓔ move along the flat region (b) rather than along the protrusion (a). Therefore, the carrier electrons may not likely meet the crystal defect (D), and thus leakage can be suppressed to increase the output power of the light emitting device 102.

In the second embodiment, the electrical resistance of the reliability enhancement layer 135 may be greater than that of the second conductive type third semiconductor layer 112b. For example, the reliability enhancement layer 135 may include InₓAl_{y}Ga_{(1-x-y)}N (0≤x≤1, 0≤y≤1) that has an energy band gap greater than that of the second conductive type third semiconductor layer 112b so that the reliability enhancement layer 135 can be chemically stable and have electrical resistance greater than that of the second conductive type third semiconductor layer 112b.

Therefore, electrons flow around the protrusion (a) rather than flow through the protrusion (a) because resistance is relatively low at a region around the protrusion (a).

In the current embodiment, since the reliability enhancement layer 135 is disposed in the second conductive type semiconductor layer 112, current leakage caused by crystal dislocation defects can be effectively prevented, and thus a highly reliable high-power light emitting device can be provided for a large light system.

In addition, since a current is blocked by the reliability enhancement layer 135, light extraction efficiency can be improved by a current spreading effect, and thus a high-power light emitting device can be provided.

In the current embodiment, a second electrode layer 120 may be disposed under the second conductive type second semiconductor layer 112a to effectively supply carriers and thus to increase the output power of the light emitting device 102. The second electrode layer 120 may include an ohmic layer 122, a reflection layer 124, a coupling layer 126, and a second substrate 128. However, the second electrode layer 120 is not limited thereto.

Furthermore, in the current embodiment, a current diffusion layer 131 and a strain control layer 132 may be disposed between the second conductive type second semiconductor layer 112a and the active layer 115, and an electron block layer 133 may be disposed between the active layer 115 and the first conductive type first semiconductor layer 111.

As described above, embodiments can provide a light emitting device having improved electric and optical characteristics, a method of manufacturing a light emitting device, a light emitting device package, and a lighting system.

In addition, embodiments can provide a highly reliable and high-power light emitting device in which a reliability enhancement layer is disposed in a second conductive type semiconductor layer to prevent current leakage caused by crystalline dislocation, a method of manufacturing a light emitting device, a light emitting device package, and a lighting system.

In addition, embodiments can provide a high-power light emitting device in which a current is blocked by a reliability enhancement layer to increase light emitting efficiency by a current spreading effect, a method of manufacturing a light emitting device, a light emitting device package, and a lighting system.

Hereinafter, a method of manufacturing a light emitting device and technical characteristics thereof will be described according to the second embodiment with reference to Figs. 12 to 18.

First, a first substrate 105 may be prepared as illustrated in Fig. 12. The first substrate 105 may include a conductive substrate or an insulating substrate. For example, the first substrate 105 may include at least one of sapphire (Al₂O₃), SiC, Si, GaAs, GaN, ZnO, GaP, InP, Ge, and Ga₂O₃.

A buffer layer (not shown) may be disposed on the first substrate 105.

Next, a second conductive type third semiconductor layer 112b is disposed on the first substrate 105.

The second conductive type third semiconductor layer 112b may be formed of a group III-V compound semiconductor doped with a second conductive type dopant. If the second conductive type third semiconductor layer 112b is an n-type semiconductor layer, the second conductive type dopant may include Si, Ge, Sn, Se, or Te as an n-type dopant. However, the second conductive type dopant is not limited thereto.

The second conductive type third semiconductor layer 112b may include a semiconductor material having a composition equation of InₚAl_{q}Ga_{1-p-q}N (0≤p≤1, 0≤q≤1, 0≤p+q≤1).

The second conductive type third semiconductor layer 112b may be formed as an n-type GaN layer by using a method such as chemical vapor deposition (CVD), molecular beam epitaxy (MBE), sputtering, or hydride vapor phase epitaxy (HVPE). The second conductive type third semiconductor layer 112b may be formed by injecting silane (SiH₄) gas including n-type impurities such as trimethyl gallium (TMGa) gas, ammonia (NH₃) gas, nitrogen (N₂) gas, and silicon (Si) into a chamber:

If the second conductive type third semiconductor layer 112b is formed of a GaN-containing material and disposed on a sapphire or silicon substrate, the GaN-containing material and the substrate may be different surface lattice constants.

Therefore, a plurality of GaN crystalline particles are formed in an early growing stage of the second conductive type third semiconductor layer 112b, and such crystalline particles meet each other as the second conductive type third semiconductor layer 112b grows up. Thus, pits (V) are formed in the second conductive type third semiconductor layer 112b at positions where crystalline particles meet each other.

The features such as sizes, density, and depths of the pits (V) can be controlled by varying thin film growth conditions such as growth temperature, pressure, rate, time, and gas injection ratio. Crystal defects (D) such as threading dislocations are located under the pits (V).

Next, as shown in Fig. 13, a reliability enhancement layer 135 is disposed on the second conductive type third semiconductor layer 112b.

For example, the reliability enhancement layer 135 may include a second conductive type InₓAl_{y}Ga(_{1-x-y})N (0≤x≤1, 0≤y≤1) and may have a single-layer or multi-layer structure. For example, the reliability enhancement layer 135 may include first and second reliability enhancement layers 135a and 135b having different energy band gaps. In this case, the aluminum composition or energy band gap of the reliability enhancement layer 135 may be gradually reduced in a growing direction or a direction toward an active layer.

Furthermore, in the current embodiment, the reliability enhancement layer 135 may have a superlattice structure formed by alternately stacking first and second reliability enhancement layer 135a and 135b having different energy band gaps.

In the current embodiment, if the reliability enhancement layer 135 has a multi-layer structure, current injection efficiency can be increased as compared with the case where the reliability enhancement layer 135 has a single-layer structure.

According to the current embodiment, as shown in Fig. 13, the pits (V) can be filled with the reliability enhancement layer 135 by adjusting growth conditions of the reliability enhancement layer 135.

The reliability enhancement layer 135 may be formed of the same kind of material as that used to form the second conductive type semiconductor layer 112 and may be doped with the same conductive type dopant as that used to dope the second conductive type semiconductor layer 112.

For example, the reliability enhancement layer 135 may include a nitride-containing semiconductor such as InₓAl_{y}Ga_{(1-x-y)}N (0≤y≤1, 0≤y≤1) and may be doped with a second conductive type dopant. For example, if the second conductive type semiconductor layer 112 include an n-type nitride semiconductor, the reliability enhancement layer 135 may include n-type InₓAl_{y}Ga_{(1-x-y})N (0≤x≤1, 0≤y≤1).

In the light emitting device 102 of the second embodiment, the energy band gap of the reliability enhancement layer 135 is greater than that of the second conductive type third semiconductor layer 112b, and the reliability enhancement layer 135 is relatively thicker than the second conductive type third semiconductor layer 112b at regions around the crystal defects (D). Therefore, leakage of a reverse or forward low current can be prevented at the regions around the crystal defects (D) such as crystal dislocations, and thus the reliability of the light emitting device 102 can be remarkably improved.

In the current embodiment, the etching rate of the reliability enhancement layer 135 may be lower than that of the second conductive type third semiconductor layer 112b. In the current embodiment, for example, the aluminum composition of the reliability enhancement layer 135 may be adjusted be greater than the aluminum composition of the second conductive type third semiconductor layer 112b or the indium composition of the reliability enhancement layer 135 may be adjusted to be less than the indium composition of the second conductive type third semiconductor layer 112b, so as to make the etching rate of the reliability enhancement layer 135 lower than that of the second conductive type third semiconductor layer 112b.

For example, in the current embodiment, as the aluminum composition of a layer increases, the chemical etching rate of the layer may decrease, and as the indium composition of the layer increases, the chemical etching rate of the layer may increase. The reason for this is that the chemical bonding between Al atoms and N atoms is stronger than the chemical bonding between Ga atoms and N atoms and the chemical bonding between Ga atoms and N atoms is stronger than the chemical bonding between In atoms and N atoms.

In the current embodiment, since the chemical etching rate of the reliability enhancement layer 135 is lower than that of the second conductive type third semiconductor layer 112b, chemical etching can be substantially stopped at the reliability enhancement layer 135. Therefore, local non-uniform excessive chemical etching of the light emitting structure 110 can be effectively stopped by the reliability enhancement layer 135.

That is, the current embodiment can provide a light emitting device in which excessive etching of a thin film can be prevented by a reliability enhancement layer, and a method of manufacturing a light emitting device.

The reliability enhancement layer 135 may be thicker at the regions around the crystal defects (D) than other regions. For example, a protrusion (a) of the reliability enhancement layer 135 may be located in a region of the crystal defect (D). In this case, the resistance of the reliability enhancement layer 135 is higher at the protrusion (a) located at the crystal defect (D) than at a flat region (b), and thus carriers such as electrons ⓔ move along the flat region (b) rather than along the protrusion (a). Therefore, the carriers may not likely meet the crystal defect (D), and thus leakage can be suppressed to increase the output power of a light emitting device.

In the current embodiment, since the reliability enhancement layer 135 is relatively thick at regions around the crystal defects (D) such as threading dislocations, current leakage can be prevented at the crystal defects (D), and thus the reliability of a light emitting device can be improved.

In the current embodiment, the electrical resistance of the reliability enhancement layer 135 may be greater than that of the second conductive type third semiconductor layer 112b. For example, the reliability enhancement layer 135 may include InₓAl_{y}Ga(_{1-x-y})N (0≤x≤1, 0≤y≤1) that has an energy band gap greater than that of the second conductive type third semiconductor layer 112b so that the reliability enhancement layer 135 can be chemically stable and have electrical resistance greater than that of the second conductive type third semiconductor layer 112b.

Therefore, electrons flow around the protrusion (a) rather than flow through the protrusion (a) because resistance is relatively low at a region around the protrusion (a).

In the current embodiment, since the reliability enhancement layer 135 is disposed in the second conductive type semiconductor layer 112, current leakage caused by crystal dislocation defects can be effectively prevented, and thus a highly reliable high-power light emitting device can be provided for a large light system.

In addition, since a current is blocked by the reliability enhancement layer 135, light extraction efficiency can be improved by a current spreading effect, and thus a high-power light emitting device can be provided.

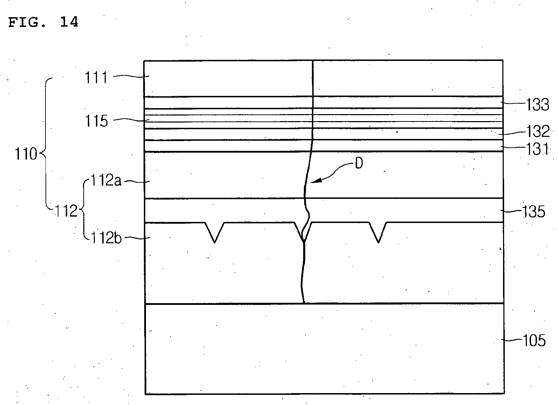

Next, as shown in Fig. 14, a second conductive type second semiconductor layer 112a is disposed on the reliability enhancement layer 135. The second conductive type second semiconductor layer 112a may be formed of the same kind of material as that used to form the second conductive type third semiconductor layer 112b.

For example, the second conductive type second semiconductor layer 112a may include a semiconductor material having a composition formula of InₚAl_{q}Ga_{1-p-q}N (0≤p≤1, 0≤q≤1, 0≤p+q≤1). However, the second conductive type second semiconductor layer 112a is not limited thereto.

Thereafter, a current diffusion layer 131 is disposed on the second conductive type second semiconductor layer 112a. The current diffusion layer 131 may be an undoped GaN layer. However, the current diffusion layer 131 is not limited thereto.

Next, according to the current embodiment, an electron injection layer (not shown) may be disposed on the current diffusion layer 131. The electron injection layer may be a second conductive type gallium nitride layer. Next, according to the current embodiment, a strain control layer 132 may be disposed on the electron injection layer.

After that, the active layer 115 is disposed on the strain control layer 132.

The active layer 115 may have at least one of a single quantum well structure, a multi quantum well (MQW) structure, a quantum-wire structure, and a quantum dot structure.

According to the current embodiment, an electron block layer 133 is disposed on the active layer 115 for blocking electrons and functioning as a MQW cladding layer for the active layer 115. That is, light extraction efficiency can be improved by forming the electron block layer 133.

Next, a first conductive type first semiconductor layer 111 is disposed on the electron block layer 133. The first conductive type first semiconductor layer 111 may include a group III-V compound semiconductor doped with a first conductive type dopant. For example, the first conductive type first semiconductor layer 111 may include a semiconductor material having a composition formula of InₓAlyGa_{1-x-y}N (0≤x≤1, 0≤y≤1, 0≤x+y≤1).

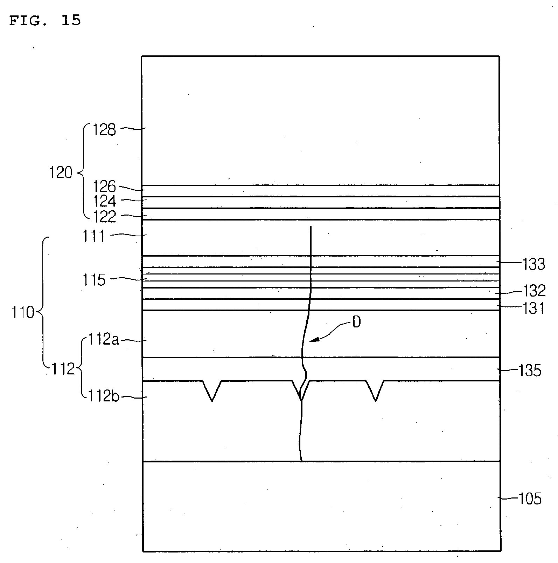

Next, as shown in Fig. 15, a second electrode layer 120 is disposed on the first conductive type first semiconductor layer 111.

The second electrode layer 120 may include an ohmic layer 122, a reflection layer 124, a coupling layer 126, and a second substrate 128.

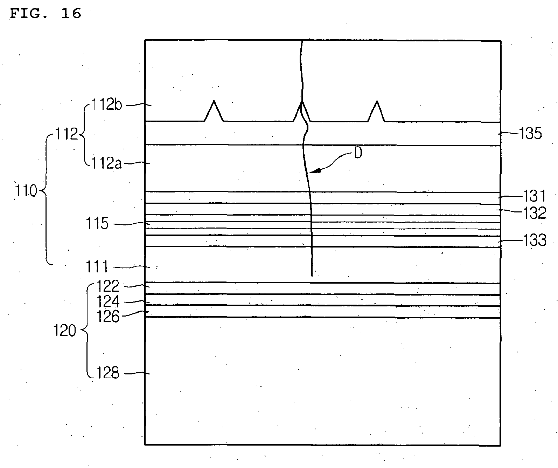

Thereafter, as illustrated in Fig. 16, the first substrate 105 is removed to expose the first conductive type semiconductor layer 112.

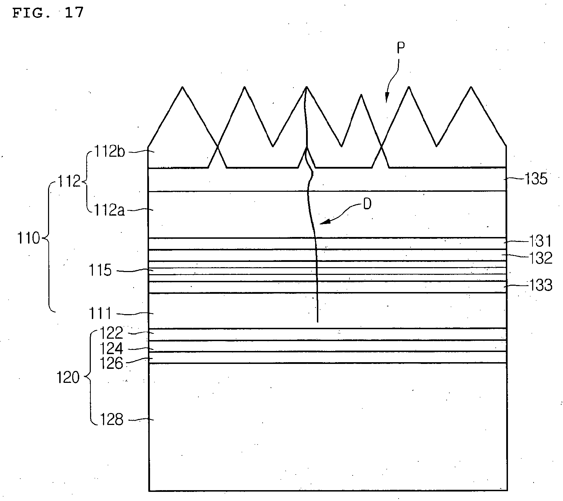

Next, according to the current embodiment, a light extraction pattern (P) may be formed on the exposed surface of the second conductive type third semiconductor layer 112b as shown in Fig. 17.

When an etching process is performed to form the light extraction pattern (P) on the second conductive type third semiconductor layer 112b, the reliability enhancement layer 135 functions as an etch stop layer to prevent the second conductive type second semiconductor layer 112a from being etched. In this way, the reliability enhancement layer 135 can improve the reliability of the etching process.

For example, in the current embodiment, when the light emitting structure 110 (epi thin layers) is separated from the first substrate 105 which may be a sapphire substrate for growing a thin film, the exposed second conductive type third semiconductor layer 112b may have a flat surface. Then, the surface of the second conductive type third semiconductor layer 112b may be made rough by a chemical etching method to improve light extraction efficiency. For example, the light extraction pattern (P) may be formed on the second conductive type third semiconductor layer 112b to make rough the surface of the second conductive type third semiconductor layer 112b.

In the current embodiment, the etching rate of the reliability enhancement layer 135 may be lower than that of the second conductive type third semiconductor layer 112b.

In the current embodiment, since the chemical etching rate of the reliability enhancement layer 135 is lower than that of the second conductive type third semiconductor layer 112b, chemical etching can be substantially stopped at the reliability enhancement layer 135. Therefore, local non-uniform excessive chemical etching of the light emitting structure 110 can be effectively stopped by the reliability enhancement layer 135.

In the light emitting device 102 of the second embodiment, the energy band gap of the reliability enhancement layer 135 is greater than that of the second conductive type third semiconductor layer 112b, and the reliability enhancement layer 135 is relatively thicker than the second conductive type third semiconductor layer 112b at regions around the crystal defects (D). Therefore, leakage of a reverse or forward low current can be prevented at the regions around the crystal defects (D) such as crystal dislocations, and thus the reliability of a light emitting device can be remarkably improved.

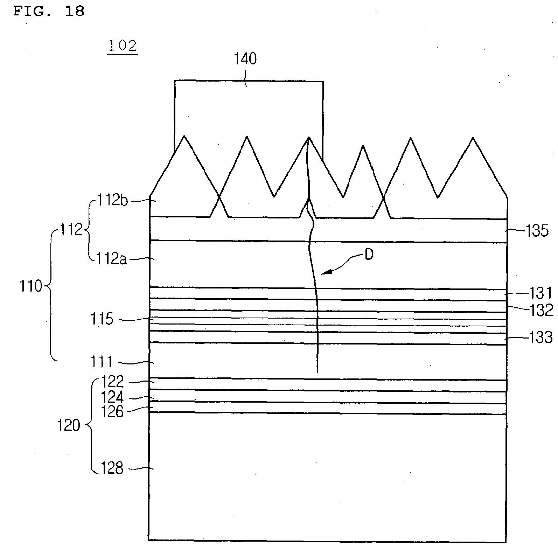

Next, as shown in Fig. 18, a pad electrode 140 is disposed on the second conductive type third semiconductor layer 112b on which the light extraction pattern (P) is formed. In this way, a light emitting device can be manufactured according to the embodiments.

As described above, embodiments can provide a light emitting device having improved electric and optical characteristics, a method of manufacturing a light emitting device, a light emitting device package, and a lighting system.

In addition, embodiments can provide a highly reliable and high-power light emitting device in which a reliability enhancement layer is disposed in a second conductive type semiconductor layer to prevent current leakage caused by crystalline dislocation, a method of manufacturing a light emitting device, a light emitting device package, and a lighting system.

In addition, embodiments can provide a high-power light emitting device in which a current is blocked by a reliability enhancement layer to increase light emitting efficiency by a current spreading effect, a method of manufacturing a light emitting device, a light emitting device package, and a lighting system.

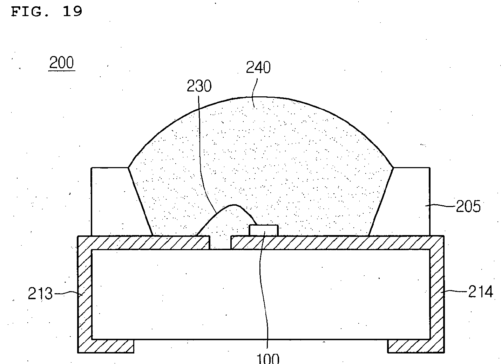

Fig. 19 is a cross-sectional view illustrating a light emitting device package 200 provided with a light emitting devices according to an embodiment.

In the current embodiment, the light emitting device package 200 includes: a package body 205, a third electrode layer 213 and a fourth electrode layer 214 disposed in the package body 205, a light emitting device 100 disposed in the package body 205 and electrically connected to the third electrode layer 213 and the fourth electrode layer 214, and a molding member 240 surrounding the light emitting device 100.

The package body 205 may be formed of a silicone material, a synthetic resin material, or a metal material. An inclined surface may be formed around the light emitting device 100.

The third electrode layer 213 and the fourth electrode layer 214 are electrically separated from each other to supply power to the light emitting device 100. Also, the third electrode layer 213 and the fourth electrode layer 214 may reflect light emitted from the light emitting device 100 to improve light efficiency, and may dissipate heat generated from the light emitting device 100.

The light emitting device 100 may be a vertical type light emitting device such as the light emitting device 100 of the first embodiment as shown in Fig. 1 or the light emitting device 100 of the second embodiment. Alternatively, the light emitting device 100 may be a horizontal type light emitting device.

The light emitting device 100 may be disposed on the package body 205, the third electrode layer 213, or the fourth electrode layer 214.

The light emitting device 100 may be connected to the third electrode layer 213 and/or the fourth electrode layer 214 by one of a wire bonding method, a flip chip bonding method, and a die bonding method. In the current embodiment, the light emitting device 100 is electrically connected to the third electrode layer 213 through a wire 230 and to the fourth electrode layer 214 by direct contact.

The molding member 240 may surround the light emitting device 100 to protect the light emitting device 100. The molding member 240 may include a fluorescent material to vary the wavelength of light emitted form the light emitting device 100.

In the current embodiment, a plurality of light emitting device packages 200 may be arranged on a board, and optical members such as a light guide plate, a prism sheet, a spread sheet, and a fluorescent sheet may be disposed along a path of light emitted from the light emitting device packages 200. The light emitting device packages 200, the board, and the optical members may function as a backlight unit or lighting unit. For example, a lighting system may include a backlight unit, a lighting unit, an indicator unit, a lamp, a streetlamp, etc.

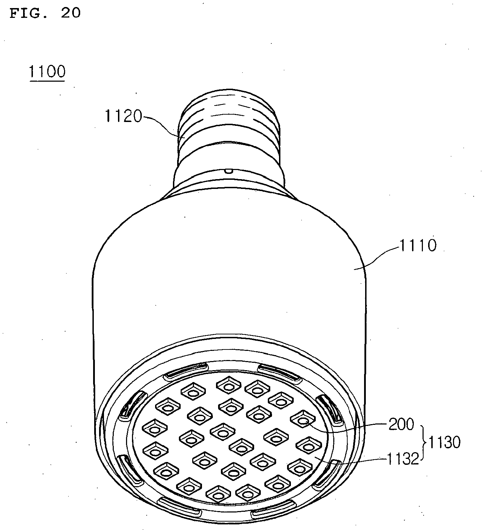

Fig. 20 is a perspective view of a lighting unit 1100 according to an embodiment. The lighting unit 1100 shown in Fig. 20 is an example of lighting systems. However, the scope of the present disclosure is not limited thereto.

In the current embodiment, the lighting unit 1100 may include a case body 1110, a light emitting module part 1130 disposed in the case body 1110, and a connection terminal 1120 disposed on the case body 1110 to receive power from an external power supply.

The case body 1110 may be formed of a material having good heat dissipation characteristics, such as a metal material or a resin material.

The light emitting module part 1130 may include a board 1132 and at least one light emitting device package 200 disposed on the board 1132.

The board 1132 may be a board in which circuit patterns are printed on an insulator. Examples of the board 1132 may include a general printed circuit board (PCB), a metal core PCB, a flexible PCB, and a ceramic PCB.

In addition, the board 1132 may be formed of a material capable of efficiently reflecting light. Alternatively, the board 1132 may have a surface having a color capable of efficiently reflecting light, such as a white color, or a silver color.

The at least one light emitting device package 200 may be disposed on the board 1132. The light emitting device package 200 may include at least one light emitting diode (LED) 100. Examples of the LED 100 include: a color diode capable of emitting color light such as red light, green light, blue light, or white light; and an ultraviolet (UV) LED capable of emitting UV rays.

The light emitting module part 1130 may have a combination of various light emitting device packages 200 to obtain desired color tone and luminance. For example, the light emitting module part 1130 may include a combination of a white LED, a red LED, and a green LED to ensure a high color rendering index (CRI).

The connection terminal 1120 may be electrically connected to the light emitting module part 1130 to supply power. In the current embodiment, the connection terminal 1120 may be a screw terminal that can be coupled to an external power source socket. However, the connection terminal 1120 is not limited thereto. For example, the connection terminal 1120 may be formed in a pin shape. In this case, the connection terminal 1120 may be inserted into an external power source or connected to the external power source by using a cable.

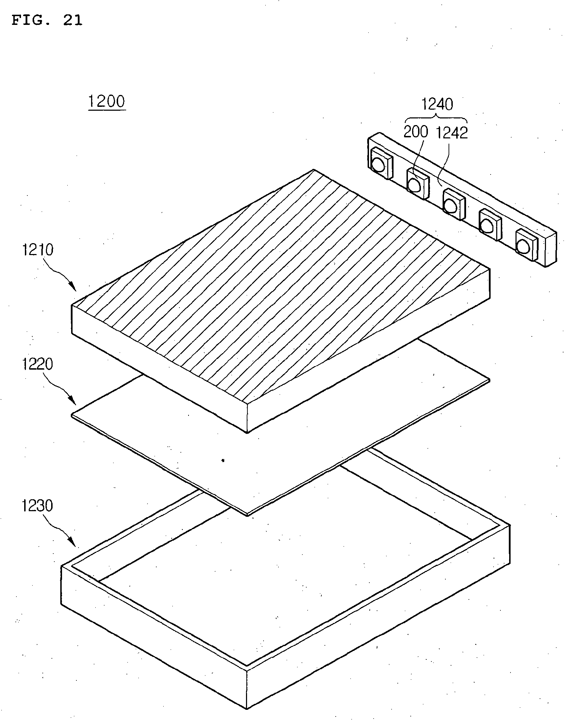

Fig. 21 is an exploded perspective view illustrating a backlight unit 1200 according to an embodiment. The backlight unit 1200 shown in Fig. 21 is a non-limiting example of lighting systems.

The backlight unit 1200 of the current embodiment may include a light guide plate 1210, a light emitting module part 1240 supplying light to the light guide plate 1210, a reflection member 1220 below the light guide plate 1210, and a bottom cover 1230 accommodating the light guide plate 1210, the light emitting module part 1240, and the reflection member 1220. However, the backlight unit 1200 is not limited to this configuration.

The light guide plate 1210 diffuses light to produce planar light. The light guide plate 1210 may be formed of a transparent material. For example, the light guide plate 1210 may include one of an acrylic resin-containing material such as polymethylmethacrylate (PMMA), a polyethylene terephthalate (PET) resin, a poly carbonate (PC) resin, a cyclic olefin copolymer (COC) resin, and a polyethylene naphthalate (PEN) resin.

The light emitting module part 1240 provides light to at least one side surface of the light guide plate 1210. The light emitting module part 1240 may be used as a light source of a display device in which the backlight unit 1200 is disposed.

The light emitting module part 1240 may make contact with the light guide plate 1210. However, the light emitting module part 1240 is not limited to this structure. In detail, the light emitting module part 1240 includes a board 1242 and a plurality of light emitting device packages 200 disposed on the board 1242. The board 1242 may make contact with the light guide plate 1210. However, the board 1242 is not limited to this structure.

The board 1242 may be a PCB including circuit patterns (not shown). The board 1242 may include a metal core PCB (MCPCB), a flexible PCB (FPCB) as well as a general PCB. However, the board 1242 is not limited thereto.

The plurality of light emitting device packages 200 may be disposed on the board 1242 in a manner such that light emitting surfaces of the light emitting device packages 200 are spaced a predetermined distance from the light guide plate 1210.

The reflection member 1220 may be disposed below the light guide plate 1210. Light incident from the bottom surface of the light guide plate 1210 onto the reflection member 1220 is reflected upward so that the brightness of the backlight unit 1200 can be increased. The reflection member 1220 may be formed of a material such as a PET resin, a PC resin, and a polyvinylchloride (PVC) resin However, the reflection member 1220 is not limited thereto.

The bottom cover 1230 may accommodate the light guide plate 1210, the light emitting module part 1240, and the reflection member 1220. For this purpose, the bottom cover 1230 may be formed in a box shape with a top surface opened. However, the shape of the bottom cover 1230 not limited thereto.

The bottom cover 1230 may be formed of a metal material or a resin material. The bottom cover 1230 may be manufactured through a process such as a press forming process or an extrusion process.

As described above, embodiments can provide a light emitting device having improved electric and optical characteristics, a method of manufacturing a light emitting device, a light emitting device package, and a lighting system.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a first conductive type first semiconductor layer (111);
an active layer (115) on the first conductive type first semiconductor layer;
a second conductive type second semiconductor layer (112a) on the active layer; **characterized by**
a reliability enhancement layer (135) on the second conductive type second semiconductor layer; and
a second conductive type third semiconductor layer (112b) on the reliability enhancement layer and comprising a light extraction pattern,
wherein the reliability enhancement layer and the active layer are spaced apart from each other by a distance (d) of 0.3 µm to 5 µm.

2. The light emitting device according to claim 1, wherein the reliability enhancement layer has a thickness of 5 nm to 200 nm.

3. The light emitting device according to claim 1, wherein the reliability enhancement layer comprises InₓAlyGa(_{1-x-y})N where 0≤x≤1 and 0 < y≤1.

4. The light emitting device according to claim 3, wherein the second conductive type third semiconductor layer comprises a semiconductor material having a composition formula of InₚAl_{q}Ga_{1-p-q}N where 0≤p≤1, 0≤q≤1, and 0≤p+q≤1, wherein an aluminum composition (y) of the reliability enhancement layer is greater than an aluminum composition (q) of the second conductive type third semiconductor layer.

5. The light emitting device according to claim 4, wherein the aluminum composition (y) of the reliability enhancement layer satisfies the following formula: q+0.05≤y≤q+0.5 where 0≤q≤0.5.

6. The light emitting device according to claim 3, wherein if the second conductive type third semiconductor layer comprises a semiconductor material having a composition formula of TnₚAl_{q}Ga_{1-p-q}N where 0≤p≤1, 0≤q≤1, and 0≤p+q≤1, an indium composition of the reliability enhancement layer is less than that of the second conductive type third semiconductor layer.

7. The light emitting device according to one claim among claims 1 to 6 , wherein the reliability enhancement layer has an energy band gap greater than that of the second conductive type third semiconductor layer.

8. The light emitting device according to one claim among claims 1 to 6, wherein the reliability enhancement layer comprises first and second reliability enhancement layers having different energy band gaps.

9. The light emitting device according to one claim among claims 1 to 8, wherein the reliability enhancement layer has an aluminum composition or energy band gap gradually reducing toward the active layer.

10. The light emitting device according to one claim among claims 1 to 9, wherein the reliability enhancement layer has an indium composition gradually increasing toward the active layer.

11. The light emitting device according to one claim among claims 1 to 10, wherein the reliability enhancement layer has a superlattice structure formed by alternately stacking first and second reliability enhancement layers having different energy band gaps.

12. The light emitting device according to one claim among claims 1 to 11, wherein the reliability enhancement layer comprises a protrusion on the second conductive type second semiconductor layer.

13. The light emitting device according to one claim among claims 1 to 12, wherein the reliability enhancement layer is thicker at a region around a crystal defect than at other regions.

14. The light emitting device according to claim 12 or claim 13, wherein the protrusion of the reliability enhancement layer is located at the region around the crystal defect.

15. The light emitting device according to one claim among claims 1 to 14, wherein an electric resistance of the reliability enhancement layer (135) is greater than that of the second conductive type third semiconductor layer.

## Patentansprüche

1. Lichtemittierende Vorrichtung, umfassend:
eine erste Halbleiterschicht (111) eines ersten Leitfähigkeitstyps;
eine aktive Schicht (115) auf der ersten Halbleiterschicht des ersten Leitfähigkeitstyps;
eine zweite Halbleiterschicht (112a) eines zweiten Leitfähigkeitstyps auf der aktiven Schicht; **gekennzeichnet durch**
eine Schicht (135) zur Erhöhung der Zuverlässigkeit auf der zweiten Halbleiterschicht des zweiten Leitfähigkeitstyps und
eine dritte Halbleiterschicht (112b) des zweiten Leitfähigkeitstyps auf der Schicht zur Erhöhung der Zuverlässigkeit, die ein Lichtauskopplungsmuster umfasst,
wobei die Schicht zur Erhöhung der Zuverlässigkeit und die aktive Schicht um einen Abstand (d) von 0,3 µm bis 5 µm voneinander beanstandet sind.

2. Lichtemittierende Vorrichtung nach Anspruch 1, wobei die Schicht zur Erhöhung der Zuverlässigkeit eine Stärke von 5 nm bis 200 nm aufweist.

3. Lichtemittierende Vorrichtung nach Anspruch 1, wobei die Schicht zur Erhöhung der Zuverlässigkeit InₓAl_{y}Ga_{(1-x-y},₎N umfasst, wobei 0 ≤ x ≤ 1 und 0 < y ≤ 1 ist.

4. Lichtemittierende Vorrichtung nach Anspruch 3, wobei die dritte Halbleiterschicht des zweiten Leitfähigkeitstyps ein Halbleitermaterial der Zusammensetzungsformel InₚAl_{q}Ga_{1-p-q}N umfasst, wobei 0 ≤ p ≤ 1, 0 ≤ q ≤ 1 und 0 ≤ p + q ≤ 1 ist, wobei eine Aluminiumzusammensetzung (y) der Schicht zur Erhöhung der Zuverlässigkeit größer als eine Aluminiumzusammensetzung (q) der dritten Halbleiterschicht des zweiten Leitfähigkeitstyps ist.

5. Lichtemittierende Vorrichtung nach Anspruch 4, wobei die Aluminiumzusammensetzung (y) der Schicht zur Erhöhung der Zuverlässigkeit folgender Formel entspricht: q + 0,05 ≤ y ≤ q + 0,5, wobei 0 ≤ q ≤ 0,5 ist.

6. Lichtemittierende Vorrichtung nach Anspruch 3, wobei, wenn die dritte Halbleiterschicht des zweiten Leitfähigkeitstyps ein Halbleitermaterial der Zusammensetzungsformel InₚAl_{q}Ga_{1-p-q}N umfasst, wobei 0 ≤ p ≤ 1, 0 ≤ q ≤ 1 und 0 ≤ p + q ≤ 1 ist, eine Indiumzusammensetzung der Schicht zur Erhöhung der Zuverlässigkeit geringer als die der dritten Halbleiterschicht des zweiten Leitfähigkeitstyps ist.

7. Lichtemittierende Vorrichtung nach einem der Ansprüche 1 bis 6 , wobei die Schicht zur Erhöhung der Zuverlässigkeit eine Energiebandlücke aufweist, die größer als die der dritten Halbleiterschicht des zweiten Leitfähigkeitstyps ist.

8. Lichtemittierende Vorrichtung nach einem der Ansprüche 1 bis 6, wobei die Schicht zur Erhöhung der Zuverlässigkeit erste und zweite Schichten zur Erhöhung der Zuverlässigkeit mit unterschiedlichen Energiebandlücken umfasst.

9. Lichtemittierende Vorrichtung nach einem der Ansprüche 1 bis 8, wobei die Schicht zur Erhöhung der Zuverlässigkeit eine Aluminiumzusammensetzung oder Energiebandlücke aufweist, die zur aktiven Schicht hin graduell abnimmt.

10. Lichtemittierende Vorrichtung nach einem der Ansprüche 1 bis 9, wobei die Schicht zur Erhöhung der Zuverlässigkeit eine Indiumzusammensetzung aufweist, die zur aktiven Schicht hin graduell zunimmt.

11. Lichtemittierende Vorrichtung nach einem der Ansprüche 1 bis 10, wobei die Schicht zur Erhöhung der Zuverlässigkeit eine Übergitterstruktur aufweist, die durch abwechselndes Stapeln der ersten und zweiten Schichten zur Erhöhung der Zuverlässigkeit mit unterschiedlichen Energiebandlücken ausgebildet ist.

12. Lichtemittierende Zusammensetzung nach einem der Ansprüche 1 bis 11, wobei die Schicht zur Erhöhung der Zuverlässigkeit einen Vorsprung auf die zweite Halbleiterschicht des zweiten Leitfähigkeitstyps umfasst.

13. Lichtemittierende Zusammensetzung nach einem der Ansprüche 1 bis 12, wobei die Schicht zur Erhöhung der Zuverlässigkeit an einem Bereich um einen Kristalldefekt dicker als an anderen Bereichen ist.

14. Lichtemittierende Vorrichtung nach Anspruch 12 oder Anspruch 13, wobei sich der Vorsprung der Schicht zur Erhöhung der Zuverlässigkeit am Bereich um den Kristalldefekt befindet.

15. Lichtemittierende Vorrichtung nach einem der Ansprüche 1 bis 14, wobei ein elektrischer Widerstand der Schicht zur Erhöhung der Zuverlässigkeit (135) größer als der der dritten Halbleiterschicht des zweiten Leitfähigkeitstyps ist.

## Revendications

1. Dispositif électroluminescent comprenant :
une première couche de semiconducteur d'un premier type de conductivité (111) ;
une couche active (115) sur la première couche de semiconducteur du premier type de conductivité ;
une deuxième couche de semiconducteur d'un second type de conductivité (112a) sur la couche active ;
**caractérisé par**
une couche d'amélioration de fiabilité (135) sur la deuxième couche de semiconducteur du second type de conductivité ; et
une troisième couche de semiconducteur du second type de conductivité (112b) sur la couche d'amélioration de fiabilité et comprenant un motif d'extraction de lumière,
dans lequel la couche d'amélioration de fiabilité et la couche active sont séparées l'une de l'autre par une distance (d) de 0,3 µm à 5 µm.

2. Dispositif électroluminescent selon la revendication 1, dans lequel la couche d'amélioration de fiabilité a une épaisseur de 5 nm à 200 nm.

3. Dispositif électroluminescent selon la revendication 1, dans lequel la couche d'amélioration de fiabilité comprend du InₓAl_{y}Ga(_{1-x-y})N, où 0≤x≤1 et 0<y≤1.

4. Dispositif électroluminescent selon la revendication 3, dans lequel la troisième couche de semiconducteur du second type de conductivité comprend un matériau semiconducteur ayant une formule de composition InₚAl_{q}Ga_{1-p-q}N, où 0≤p≤1, 0≤q≤1 et 0≤p+q≤1, dans lequel une composition en aluminium (y) de la couche d'amélioration de fiabilité est supérieure à une composition en aluminium (q) de la troisième couche de semiconducteur du second type de conductivité.

5. Dispositif électroluminescent selon la revendication 4, dans lequel la composition en aluminium (y) de la couche d'amélioration de fiabilité respecte la formule suivante : q+0,05≤y≤q+0,5, où 0≤q≤0,5.

6. Dispositif électroluminescent selon la revendication 3, dans lequel si la troisième couche de semiconducteur du second type de conductivité comprend un matériau semiconducteur ayant une formule de composition InₚAl_{q}Ga_{1-p-q}N, où 0≤p≤1, 0≤q≤1 et 0≤p+q≤1, une composition en indium de la couche d'amélioration de fiabilité est inférieure à celle de la troisième couche de semiconducteur du second type de conductivité.

7. Dispositif électroluminescent selon une revendication parmi les revendications 1 à 6, dans lequel la couche d'amélioration de fiabilité a une bande d'énergie interdite supérieure à celle de la troisième couche de semiconducteur du second type de conductivité.

8. Dispositif électroluminescent selon une revendication parmi les revendications 1 à 6, dans lequel la couche d'amélioration de fiabilité comprend des première et deuxième couches d'amélioration de fiabilité ayant des bandes d'énergie interdite différentes.

9. Dispositif électroluminescent selon une revendication parmi les revendications 1 à 8, dans lequel la couche d'amélioration de fiabilité a une composition en aluminium ou une bande d'énergie interdite diminuant progressivement vers la couche active.

10. Dispositif électroluminescent selon une revendication parmi les revendications 1 à 9, dans lequel la couche d'amélioration de fiabilité a une composition en indium augmentant progressivement vers la couche active.

11. Dispositif électroluminescent selon une revendication parmi les revendications 1 à 10, dans lequel la couche d'amélioration de fiabilité a une structure en super-réseau formée en empilant alternativement des première et deuxième couches d'amélioration de fiabilité ayant différentes bandes d'énergie interdite.

12. Dispositif électroluminescent selon une revendication parmi les revendications 1 à 11, dans lequel la couche d'amélioration de fiabilité comprend une partie saillante de la deuxième couche de semiconducteur du second type de conductivité.

13. Dispositif électroluminescent selon une revendication parmi les revendications 1 à 12, dans lequel la couche d'amélioration de fiabilité est plus épaisse au niveau d'une région située autour d'un défaut de cristal qu'au niveau d'autres régions.

14. Dispositif électroluminescent selon la revendication 12 ou la revendication 13, dans lequel la partie saillante de la couche d'amélioration de fiabilité est située au niveau de la région située autour du défaut de cristal.

15. Dispositif électroluminescent selon une revendication parmi les revendications 1 à 14, dans lequel une résistance électrique de la couche d'amélioration de fiabilité (135) est supérieure à celle de la troisième couche de semiconducteur du second type de conductivité.
